# FASCICULE DE BREVET EUROPEEN

(11) **EP 3 011 588 B1**
(45) Date de publication et mention de la délivrance du brevet: **30.01.2019**
(21) Numéro de dépôt: 14750526.7
(22) Date de dépôt: 16.06.2014
(51) Int. Cl.: H01L 21/56, H01L 21/78, H01L 25/00

(54) **PROCÉDÉ DE TRANSFERT D'UNE COUCHE DE CIRCUITS**
VERFAHREN ZUR ÜBERFÜHRUNG EINER SCHICHT VON SCHALTUNGEN
METHOD FOR TRANSFERRING A LAYER OF CIRCUITS

(30) Priorité: 19.06.2013 FR 1355765
(43) Date de publication de la demande: 27.04.2016
(73) Titulaire: Soitec, 38190 Bernin (FR)
(72) Inventeur: BROEKAART, Marcel, F-38570 Theys (FR); MARINIER, Laurent, F-38660 La Terrasse (FR)
(74) Mandataire: IP Trust
(86) Numéro de dépôt international: PCT/FR2014/051478
(87) Numéro de publication internationale: WO 2014/202886

(56) Documents cités:
- WO-A2-2011/082857
- US-A- 5 071 792
- US-A1- 2007 020 873

## Description

### DOMAINE DE L'INVENTION

L'invention se situe dans le domaine de l'électronique, l'optique et/ou l'optoélectronique.

La présente invention concerne plus précisément un procédé de transfert d'une couche de circuits enterrée.

Différents composants électroniques sont fabriqués à partir d'un substrat incluant une telle couche de circuits enterrée. Parmi ceux-ci, on peut citer à titre d'exemple, les capteurs utilisant la technologie de l'illumination par la face arrière, (connus de l'homme du métier sous l'acronyme de "BSI sensor", pour "*Backside Illumination sensor*"). Ils sont basés sur une nouvelle disposition des différentes couches les constituant. Ces capteurs permettent d'augmenter la quantité de lumière capturée et sont donc plus performants. Ils sont destinés à être utilisés notamment dans les écrans des tablettes et téléphones de dernière génération.

### ARRIERE-PLAN DE L'INVENTION

L'amincissement d'un substrat utilisé dans les domaines techniques précités peut s'effectuer par exemple par gravure chimique.

Lorsque l'on amincit un substrat du type semi-conducteur sur isolant (SeOI), la gravure chimique est relativement facile à employer parce que la couche d'oxyde enterrée sert de couche d'arrêt de gravure. Lorsqu'il s'agit d'un substrat massif, l'amincissement est un peu plus complexe puisqu'il est alors nécessaire de créer une couche d'arrêt de gravure, par exemple par dopage de type p ou n dudit substrat massif.

Toutefois, dans le cas particulier où le substrat donneur comprend une couche de circuits enterrée, la gravure chimique de la couche de matériau qui recouvre ladite couche de circuits enterrée devient vraiment problématique. En effet, les solutions chimiques utilisées (par exemple l'acide sulfurique (H₂SO₄), l'acide phosphorique (H₃PO₄) ou l'acide fluorhydrique (HF) dans le cas de la gravure du silicium) sont particulièrement agressives vis-à-vis des métaux et donc de la couche comportant lesdits circuits.

Il en résulte une gravure latérale de cette couche de circuits enterrée qui peut atteindre un centimètre ou plus depuis le bord. Les capteurs BSI fabriqués au niveau de cette zone endommagée sont alors inutilisables.

On connait déjà d'après le document EP 1 962 325, un procédé de fabrication d'un substrat collé, par transfert de couches, qui comprend des étapes de réalisation d'une rainure périphérique sur la face avant d'un substrat donneur, d'oxydation thermique de ce substrat, de collage d'un substrat receveur sur ladite face avant et d'amincissement dudit substrat donneur depuis sa face arrière, jusqu'à atteindre le fond de ladite rainure.

Un tel procédé permet de transférer uniquement sur le substrat receveur, la partie centrale du substrat donneur et d'éliminer la partie périphérique mal collée de celui-ci.

Ce document ne décrit toutefois absolument pas le traitement de substrats donneurs comprenant une couche de circuits enterrée et d'ailleurs une telle couche ne supporterait pas L'oxydation thermique réalisée, ni le traitement thermique après collage à plus de 1000°C, décrits dans ce document.

Le document WO 2011 082 857 décrit un procédé de fabrication dans lequel un substrat contenant des circuits est aminci par gravure, ce procédé impliquant une couche d'arrêt qui remplit des tranchées entre les circuits.

L'invention a donc pour but de proposer un procédé de transfert d'une couche de circuits enterrée qui résolve les inconvénients précités de l'état de la technique et notamment, qui évite l'endommagement de ces circuits.

A cet effet, l'invention concerne un procédé de transfert d'une couche de circuits (2) enterrée.

Conformément à l'invention, ce procédé comprend les étapes suivantes :
- prendre un substrat donneur comprenant intérieurement une zone d'arrêt de la gravure et recouvert sur l'une de ses faces, dite "avant", d'une couche de circuits,
- réaliser sur toute la circonférence dudit substrat donneur, du côté de sa face recouverte de la couche de circuits, soit une tranchée périphérique qui s'étend à distance du bord latéral de ce substrat, inférieure à 5 mm, soit un détourage périphérique, ce détourage ou cette tranchée étant réalisés sur une profondeur telle qu'ils traversent entièrement la couche de circuits et se prolongent dans le substrat donneur,
- déposer sur la face exposée de ladite couche de circuits et sur la face détourée ou sur les parois de ladite tranchée, une couche d'un matériau d'arrêt sélectif vis-à-vis de la gravure de ladite couche de circuits, dite "deuxième couche d'arrêt", sans obturer ladite tranchée,
- coller un substrat receveur sur ledit substrat donneur du côté recouvert par ladite deuxième couche d'arrêt,
- amincir le substrat donneur (1) par gravure chimique de sa face arrière, jusqu'à atteindre ladite zone d'arrêt de la gravure, de façon à obtenir le transfert de ladite couche de circuits enterrée sur ledit substrat receveur.

Selon d'autres caractéristiques avantageuses et non limitatives de l'invention, prises seules ou en combinaison :
- ladite zone d'arrêt de la gravure est une couche dite "première couche d'arrêt", d'un matériau sélectif vis-à-vis de la gravure du matériau de la partie arrière du substrat donneur ;
- ladite zone d'arrêt de la gravure est une interface entre une couche avant dopée et une couche arrière non dopée du substrat donneur ;
- le détourage périphérique ou la tranchée périphérique présente une profondeur telle qu'il ou qu'elle traverse ladite zone d'arrêt de la gravure, sans pénétrer dans la partie arrière ou la couche arrière du substrat donneur ;
- le détourage périphérique ou la tranchée périphérique est réatisé(e) sur une profondeur telle qu'il ou qu'elle ne traverse pas ladite zone d'arrêt de la gravure et en ce que, après l'étape d'amincissement par gravure chimique, on procède à une étape supplémentaire d'élimination mécanique de la couronne périphérique résiduelle du substrat donneur, notamment par meulage ou polissage mécano-chimique (CMP) ;
- le détourage périphérique ou la tranchée périphérique présente une profondeur telle qu'il ou qu'elle traverse ladite zone d'arrêt de la gravure et se prolonge dans la partie arrière ou la couche arrière du substrat donneur et en ce que, après l'étape d'amincissement par gravure chimique, on procède à une étape supplémentaire d'élimination mécanique du résidu de ladite seconde couche d'arrêt, notamment par meulage ou polissage mécano-chimique (CMP) ;
- la deuxième couche d'arrêt est déposée par une technique choisie parmi le dépôt chimique en phase vapeur (CVD) ou le dépôt par rotation ;
- la tranchée périphérique est réalisée à l'aide d'une technique choisie parmi la gravure laser, la gravure sèche et la gravure liquide ;
- ladite tranchée périphérique est située à une distance du bord latéral du substrat donneur, inférieure ou égale à 5 mm ;
- la largeur de la tranchée est comprise entre 10 µm et 500 µm ;
- les matériaux constituant la première et la deuxième couche d'arrêt sont choisis parmi les oxydes ou les nitrures ;
- les matériaux constituant la première et la deuxième couche d'arrêt sont choisis parmi l'oxyde de silicium, l'oxynitrure de silicium ou l'oxycarbure de silicium ;
- les matériaux constituant la première et la deuxième couche d'arrêt sont identiques ;
- le substrat donneur est réalisé en un matériau semi-conducteur ;
- le collage des substrats donneur et receveur s'effectue par adhésion moléculaire.

### BREVE DESCRIPTION DES DESSINS

D'autres caractéristiques et avantages de l'invention apparaîtront de la description qui va maintenant en être faite, en référence aux dessins annexés, qui en représentent, à titre indicatif mais non limitatif, des modes de réalisation possibles.

Sur ces dessins :
- Les figures 1 à 6 sont des schémas représentant les différentes étapes d'un mode de réalisation du procédé conforme à l'invention,
- les figures 7 à 9 sont des schémas représentant quelques-unes des étapes d'un autre mode de réalisation du procédé conforme à l'invention, et
- les figures 10A à 10D et 11A à 11D sont des vues de détail et à une échelle agrandie de variantes de réalisation de certaines étapes du procédé illustré sur les figures 4 et 5.

### DESCRIPTION DETAILLEE D'UN MODE DE REALISATION

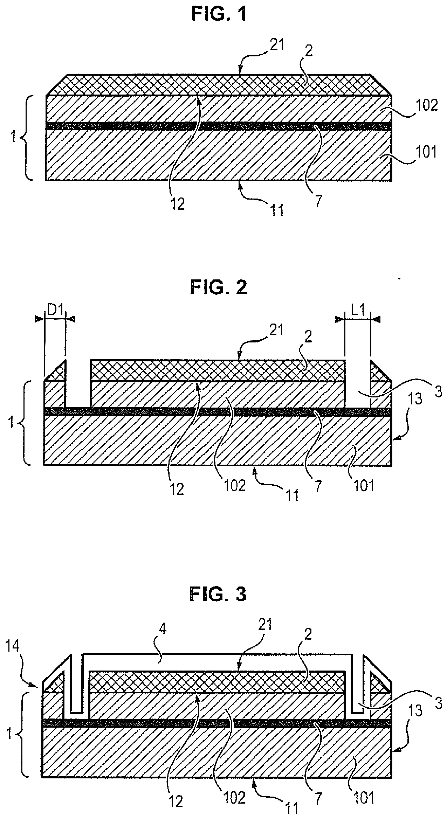

Un premier mode de réalisation de l'invention va maintenant être décrit en faisant référence aux figures 1 à 6.

Sur la figure 1, on peut voir un substrat donneur 1 présentant une face 11, dite "face arrière", et une face opposée 12, dite "face avant".

La face avant 12 est recouverte d'une couche de circuits 2.

En outre, ce substrat donneur 1 présente intérieurement une zone d'arrêt de la gravure.

Selon un premier mode de réalisation de l'invention, cette zone d'arrêt de la gravure est une couche 7 de matériau dénommée "première couche d'arrêt".

La couche d'arrêt 7 partage ainsi le substrat donneur 1 entre une partie 102, dite "avant", qui s'étend entre cette couche d'arrêt 7 et la couche de circuits 2 et une partie 101, dite "arrière", qui s'étend entre cette couche d'arrêt 7 et la face arrière 11.

Dans l'exemple représenté, ces parties avant 102 et arrière 101 sont monocouches. Toutefois, elles pourraient également être multicouches.

La première couche d'arrêt 7 est réalisée dans un matériau sélectif vis-à-vis du (des) matériau(x) constituant ledit substrat donneur 1 et notamment de sa partie arrière 101.

Cette première couche d'arrêt 7 peut être obtenue par dépôt, par exemple par dépôt chimique en phase vapeur (CVD), ou par épitaxie sur la partie arrière 101. Elle peut également être obtenue par transfert de couche.

La partie avant 102 peut être obtenue après la formation de la couche 7, par les mêmes techniques que celles précitées pour la couche 7.

Selon une autre variante de réalisation, la couche d'arrêt 7 peut également être implantée dans le substrat donneur 7, par dopage. Cette technique permet d'éviter l'étape d'ajout de la partie avant 102 évoquée précédemment.

A titre d'exemple purement illustratif, le substrat donneur 1 peut être du type "semi-conducteur sur isolant" (SEOI) ou "silicone sur isolant" (SOI). Dans ce cas, la couche d'arrêt 7 est constituée d'oxyde de silicium (SiO₂).

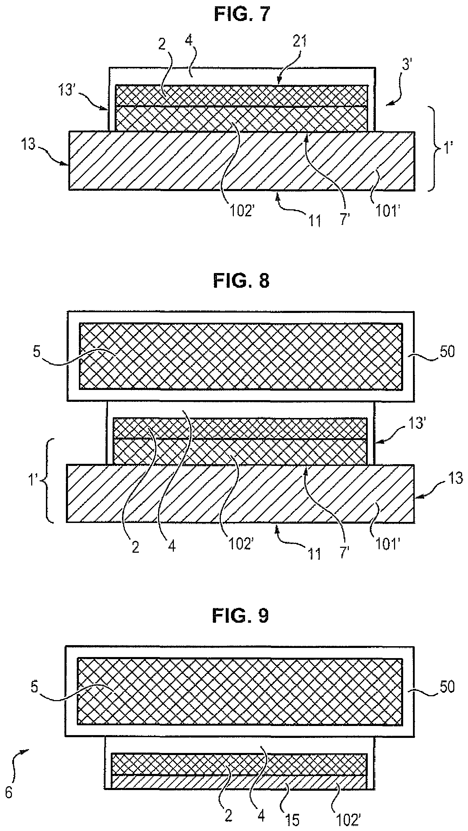

Selon un deuxième mode de réalisation de l'invention, la zone d'arrêt de la gravure peut être simplement une interface entre deux couches du substrat donneur. Cette variante de réalisation est représentée sur la figure 7. L'interface porte la référence 7' et s'étend entre une couche arrière 101' et une couche avant 102' du substrat donneur 1'.

De préférence, la couche avant 102' est une couche de même nature chimique que la couche 101', mais fortement dopée.

On notera que quel que soit le mode de réalisation de la zone d'arrêt de gravure 7, 7' celle-ci est toujours réalisée avant la formation de la couche de circuits 2.

L'étape suivante du procédé est représentée sur la figure 2 et consiste à réaliser sur toute la circonférence du substrat donneur 1, du côté de sa face recouverte par la couche de circuits 2, une tranchée périphérique 3, qui s'étend à distance du bord 13 latéral de ce substrat donneur.

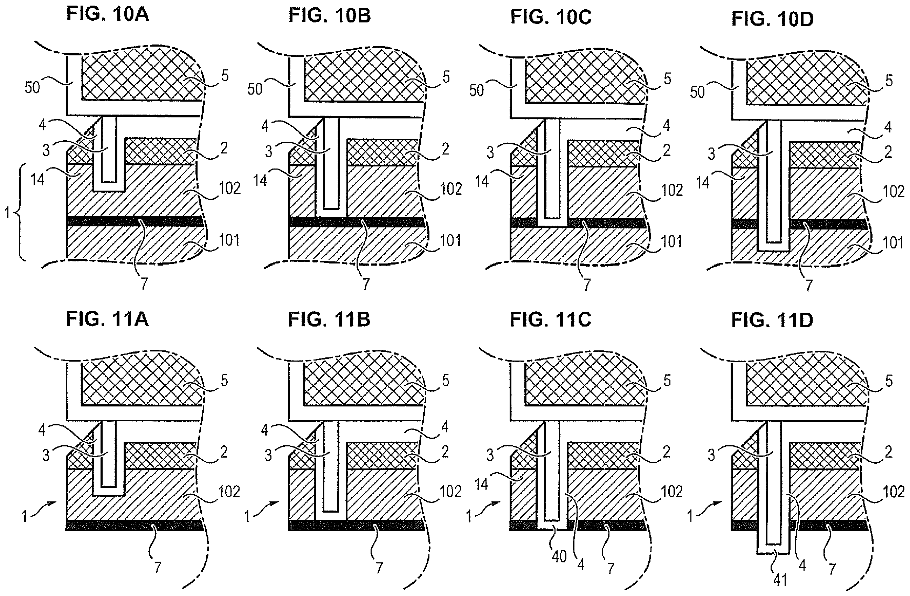

Cette tranchée 3 est réalisée sur une profondeur telle qu'elle traverse entièrement la couche de circuits 2 et qu'elle se prolonge dans le substrat donneur 1 jusqu'à une profondeur qui sera détaillée ultérieurement en liaison avec les figures 10 et 11.

De préférence, la tranchée périphérique 3 est réalisée à l'aide d'une technique choisie parmi la gravure laser, la gravure sèche et la gravure liquide. Avec les deux premières techniques, il n'est pas nécessaire de protéger la couche de circuits 2, en revanche avec la gravure liquide, il faut rajouter un masque de gravure au-dessus de la couche 2, afin de graver uniquement la partie désirée.

A titre d'exemple, la tranchée 3 présente avantageusement une largeur L1 comprise entre 10 µm et 500 µm. Par ailleurs, cette tranchée périphérique 3 est située à une distance D1 du bord 13 latéral du substrat donneur, inférieure ou égale à 5 mm. Une telle distance permet de maximiser la portion centrale conservée de la couche de circuits 2, puisque c'est celle-ci qui sera utilisée ultérieurement pour la fabrication de composants électroniques.

La face exposée 21 de la couche de circuits 2, c'est-à-dire sa face avant, ainsi que les parois intérieures latérales et de fond de la tranchée 3, sont ensuite recouvertes d'une couche 4 d'un matériau d'arrêt de la gravure, sélectif vis-à-vis de la gravure de ladite couche de circuits 2 est dite "deuxième couche d'arrêt".

Cette étape s'effectue par dépôt, de préférence par une technique choisie parmi le dépôt chimique en phase vapeur (CVD) ou le dépôt par rotation connu sous l'appellation anglaise de "spin coating". Le "dépôt par rotation" consiste à déposer un matériau visqueux sur la partie centrale du substrat et à mettre en rotation ce dernier selon un axe central.

L'étape de formation de la couche 4, illustrée sur la figure 3, est réalisée en veillant bien sûr à ne pas obturer la tranchée 3 préalablement formée. La viscosité du matériau utilisé pour former la couche 4 d'arrêt de gravure et la vitesse de rotation sont choisies de façon à ne pas obturer la tranchée 3.

Les matériaux constituant la première couche d'arrêt 7 et la seconde couche d'arrêt 4 sont de préférence choisis parmi les oxydes ou les nitrures, de préférence encore choisis parmi l'oxyde de silicium (SiO₂), l'oxynitrure de silicium (SiOₓN_{y}), l'oxycarbure de silicium (SiOₓC_{y}) ou le nitrure de silicium (Si₃N₄).

L'oxyde de silicium peut par exemple être déposé à partir de tétraéthoxysilane (TEOS) dans un plasma d'oxygène ou d'oxygène-argon.

De façon avantageuse mais non obligatoire, les matériaux constituant la première couche d'arrêt 7 et la deuxième 4 sont identiques.

La couronne périphérique de matériaux qui s'étend radialement au-delà de la tranchée 3 porte la référence 14.

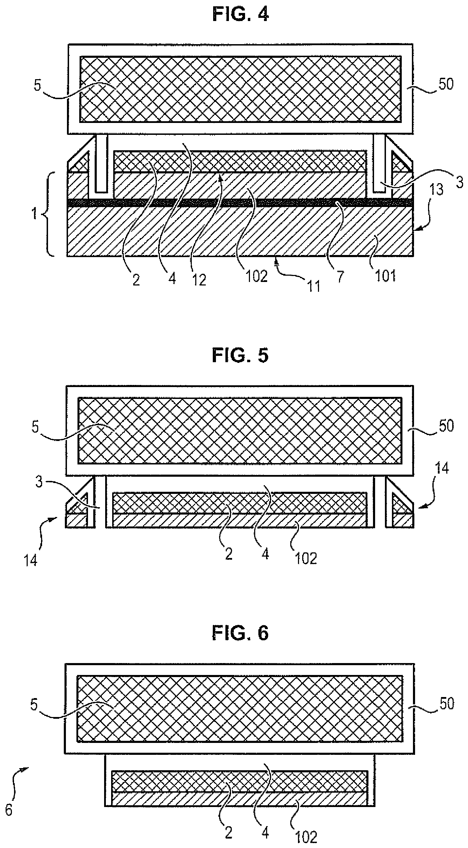

Comme représenté sur la figure 4, on procède ensuite au collage d'un substrat receveur 5 sur la deuxième couche d'arrêt 4 déposée sur le substrat donneur 1.

Ce collage s'effectue de préférence par adhésion moléculaire. On notera que le substrat donneur 5 peut éventuellement être recouvert d'une couche de collage 50, par exemple une couche d'oxyde de silicium (SiO₂) ou une couche de nitrure de silicium (Si₃N₄).

Comme on peut le voir sur la figure 5, on procède ensuite à l'amincissement du substrat donneur 1 par gravure chimique depuis sa face arrière 11, de façon à éliminer la partie arrière 101, et à atteindre la couche 7 d'arrêt de la gravure.

Cette étape a également pour effet d'éliminer la couronne périphérique 14 dudit substrat donneur, non collée sur le substrat receveur 5, soit directement, soit après une étape supplémentaire d'amincissement mécanique, comme cela sera décrit ultérieurement plus en détail.

On obtient ainsi la couche de circuits 2 enterrée sous la couche avant 102, transférée sur le substrat receveur 5. Le substrat final ainsi obtenu porte la référence 6 (voir figure 6).

La présence de la couche d'arrêt 7 et de la deuxième couche d'arrêt 4 sur la face exposée 21 et le bord latéral de la couche de circuits 2 garantit l'absence d'endommagement des circuits pendant la phase d'amincissement par gravure chimique et évite les infiltrations.

Dans le cas où la zone d'arrêt est une couche d'arrêt 7 en oxyde de silicium et où le matériau de la partie arrière 101 est du silicium, l'amincissement par gravure chimique sera avantageusement réalisé à l'aide d'un bain de tétraméthylammonium hydroxyde (TMAH) ou de KOH (hydroxyde de potassium).

Dans le cas où la zone d'arrêt est une interface d'arrêt 7', et où la couche arrière 101' est du silicium et la couche avant 102' du silicium fortement dopé, l'amincissement par gravure chimique peut s'effectuer à l'aide d'une solution d'acide sulfurique (H₂SO₄), d'une solution d'acide phosphorique (Fi₃PO₄), d'acide fluorhydrique (HF) ou d'acide propanoïque (C₂H₅COOH).

Le procédé de transfert représenté sur les figures 7 à 9 va maintenant être décrit. Il s'agit d'une variante du procédé décrit précédemment en référence aux figures 1 à 6. Les mêmes éléments portent les mêmes références numériques.

Dans ce cas, le substrat donneur, référencé 1', est soumis à un détourage périphérique. La partie détourée porte la référence 3'.

Ce détourage est réalisé sur toute la circonférence du substrat donneur 1' et sur une profondeur telle qu'il traverse entièrement la couche de circuits 2 et se prolonge dans le substrat donneur 1'.

Ce détourage peut s'effectuer par un polissage ou un meulage, par exemple à l'aide d'un outil appliqué sur une partie du bord latéral 13 du substrat donneur 1'.

La deuxième couche d'arrêt 4 est donc déposée à la fois sur la face exposée 21 de la couche de circuits 2 et sur la face latérale détourée 13' du substrat donneur 1.

Après collage du substrat receveur 5 (voir figure 8) et amincissement chimique du substrat donneur 1 (voir figure 9), on obtient la couche de circuits 2 transférée sur le substrat receveur 5, soit directement, soit après une étape supplémentaire de polissage mécanique, comme cela sera décrit ultérieurement.

On obtient le substrat final référence 6', qui diffère du substrat 6 de la figure 6 en ce que la partie avant 102 est remplacée par la couche avant 102'.

Bien que l'option du détourage annulaire périphérique ait été décrite uniquement en liaison avec les figures 7 à 9, sur lesquelles le substrat donneur 1' est un substrat qui comprend une interface d'arrêt 7', il faut comprendre que cette étape de détourage pourrait également être réalisée sur le substrat donneur 1 représenté sur les figures 1 à 6, qui comprend la couche d'arrêt 7.

Inversement, le substrat donneur 1' des figures 7 à 9 pourrait être soumis à la formation de la tranchée périphérique 3, comme décrit sur les figures 1 à 6.

Dans Les différents modes de réalisation décrits précédemment, les épaisseurs de la première couche d'arrêt 7 et de la deuxième couche d'arrêt 4 se situent de préférence entre 0,01 µm et 100 µm.

Le paramètre concernant la profondeur de la tranchée périphérique 3 dans le substrat donneur 1 va maintenant être décrit en liaison avec les figures 10A à 10D et 11A à 11D. Bien que cela ne soit pas représenté sur ces figures, le raisonnement est le même si la tranchée 3 est remplacée par un détourage périphérique 3' ou si le substrat donneur est un substrat 1' présentant une interface d'arrêt 7'.

Sur la figure 10A, la tranchée 3 est réalisée sur une profondeur telle qu'elle traverse entièrement la couche de circuits 2 et se prolonge dans le substrat donneur 1 mais sans atteindre la couche d'arrêt 7.

Sur la variante représentée à la figure 10B, cette tranchée 3 atteint cette fois la couche d'arrêt 7 mais ne la traverse pas.

Dans ces deux cas de figure, après l'étape d'amincissement chimique de la partie arrière 101 et, comme on peut le voir respectivement sur les figures 11A et 11B, la couronne périphérique 14 reste rattachée à la partie avant 102 par une épaisseur de matériau plus ou moins importante. Dans ces deux cas, il sera nécessaire de réaliser une étape supplémentaire d'élimination mécanique de cette couronne résiduelle 14, notamment par un meulage ou un polissage mécano-chimique latéral.

Dans la variante de réalisation représentée sur la figure 10C, la tranchée périphérique 3 présente une profondeur telle qu'elle traverse la couche 7 d'arrêt de la gravure, sans toutefois pénétrer dans la partie arrière 101 de matériau du substrat donneur 1.

Dans ce cas, la gravure chimique est suffisante pour éliminer la couronne périphérique 14. En effet, l'épaisseur résiduelle 40 de la deuxième couche d'arrêt 4 est trop faible et donc trop fragile pour retenir la couronne périphérique 14. Cette variante est donc la variante préférentielle de réalisation de l'invention, (voir figure 11C).

Enfin, selon une quatrième variante de réalisation de l'invention, la tranchée périphérique 3 présente une profondeur telle, que non seulement elle traverse la couche 7 d'arrêt de la gravure mais qu'elle se prolonge dans la partie arrière 101, (voir figure 10D).

Dans ce cas, et comme représenté sur la figure 11D, après l'étape de gravure chimique, on constate qu'il reste une "marche" 41 du matériau de la deuxième couche d'arrêt 4. Cette marche sera alors éliminée soit du fait de sa fragilité inhérente à sa faible épaisseur, soit par un meulage ou un polissage mécano-chimique, si l'on souhaite obtenir une planéité sans défauts.

Grâce aux caractéristiques de l'invention, la couche de circuits 2 est protégée pendant son transfert et la couche 102' ou la partie avant 102 qui la recouvre peut être ajustée à l'épaisseur désirée en choisissant la position de la zone d'arrêt 7.

## Revendications

1. Procédé de transfert d'une couche de circuits (2) enterrée, **caractérisé en ce qu'**il comprend les étapes suivantes :
• prendre un substrat donneur (1,1') comprenant intérieurement une zone (7,7') d'arrêt de la gravure et recouvert sur l'une de ses faces (12), dite "avant", d'une couche de circuits (2),
• réaliser sur toute la circonférence dudit substrat donneur (1, 1'), du côté de sa face recouverte de la couche de circuits (2), soit une tranchée périphérique (3) qui s'étend à une distance du bord latéral (13) de ce substrat (1, 1') inférieure ou égale à 5mm, soit un détourage périphérique (3'), ce détourage (3') ou cette tranchée (3) étant réalisés sur une profondeur telle qu'ils traversent entièrement la couche de circuits (2) et se prolongent dans Le substrat donneur (1, 1'),
• déposer sur la face exposée (21) de ladite couche de circuits (2) et sur la face détourée (13') ou sur les parois de ladite tranchée (3), une couche d'un matériau d'arrêt (4) sélectif vis-à-vis de la gravure de ladite couche de circuits (2), dite "deuxième couche d'arrêt", sans obturer ladite tranchée (3),
• coller un substrat receveur (5) sur ledit substrat donneur (1, 1') du côté recouvert par ladite deuxième couche d'arrêt (4),
• amincir le substrat donneur (1) par gravure chimique de sa face arrière (11), jusqu'à atteindre ladite zone (7,7') d'arrêt de la gravure, de façon à obtenir le transfert de ladite couche de circuits (2) enterrée sur ledit substrat receveur (5).

2. Procédé selon la revendication 1, **caractérisé en ce que** ladite zone d'arrêt de la gravure est une couche (7) dite "première couche d'arrêt", d'un matériau sélectif vis-à-vis de la gravure du matériau de la partie arrière (101) du substrat donneur (1).

3. Procédé selon la revendication 1, **caractérisé en ce que** ladite zone d'arrêt de la gravure est une interface (7') entre une couche avant dopée (102') et une couche arrière non dopée (101') du substrat donneur (1').

4. Procédé selon l'une des revendications précédentes, **caractérisé en ce que** le détourage périphérique (3') ou la tranchée périphérique (3) présente une profondeur telle qu'il ou qu'elle traverse ladite zone (7,7') d'arrêt de la gravure, sans pénétrer dans la partie arrière (101) ou la couche arrière (101') du substrat donneur (1, 1').

5. Procédé selon l'une des revendications 1 à 3, **caractérisé en ce que** le détourage périphérique (3') ou la tranchée périphérique (3) est réalisé(e) sur une profondeur telle qu'il ou qu'elle ne traverse pas ladite zone (7, 7') d'arrêt de la gravure et **en ce que**, après l'étape d'amincissement par gravure chimique, on procède à une étape supplémentaire d'élimination mécanique de la couronne périphérique résiduelle (14) du substrat donneur (1, 1'), notamment par meulage ou polissage mécano-chimique (CMP).

6. Procédé selon l'une des revendications 1 à 3, **caractérisé en ce que** le détourage périphérique (3') ou la tranchée périphérique (3) présente une profondeur telle qu'il ou qu'elle traverse ladite zone (7, 7') d'arrêt de la gravure et se prolonge dans la partie arrière (101) ou la couche arrière (101') du substrat donneur (1, 1') et **en ce que**, après l'étape d'amincissement par gravure chimique, on procède à une étape supplémentaire d'élimination mécanique du résidu (41) de ladite seconde couche d'arrêt (4), notamment par meulage ou polissage mécano-chimique (CMP).

7. Procédé selon l'une des revendications précédentes, **caractérisé en ce que** la deuxième couche d'arrêt (4) est déposée par une technique choisie parmi le dépôt chimique en phase vapeur (CVD) ou le dépôt par rotation.

8. Procédé selon l'une des revendications précédentes, **caractérisé en ce que** la tranchée périphérique (3) est réalisée à l'aide d'une technique choisie parmi la gravure laser, la gravure sèche et la gravure liquide.

9. Procédé selon l'une des revendications précédentes, **caractérisé en ce que** la largeur (L1) de la tranchée (3) est comprise entre 10 µm et 500 µm.

10. Procédé selon l'une des revendications précédentes, **caractérisé en ce que** les matériaux constituant la première (7) et la deuxième (4) couche d'arrêt sont choisis parmi les oxydes ou les nitrures.

11. Procédé selon la revendication 10, **caractérisé en ce que** les matériaux constituant la première (7) et la deuxième (4) couche d'arrêt sont choisis parmi l'oxyde de silicium (Si02), l'oxynitrure de silicium (SiOₓN_{y}) ou l'oxycarbure de silicium (SiOₓC_{y}).

12. Procédé selon l'une des revendications précédentes, **caractérisé en ce que** les matériaux constituant la première (7) et la deuxième (4) couche d'arrêt sont identiques.

13. Procédé selon l'une des revendications précédentes, **caractérisé en ce que** le substrat donneur (1) est réalisé en un matériau semi-conducteur.

14. Procédé selon l'une des revendications précédentes, **caractérisé en ce que** le collage des substrats donneur (1) et receveur (5) s'effectue par adhésion moléculaire.

## Patentansprüche

1. Verfahren für den Transfer einer vergrabenen Schaltungsschicht (2), **dadurch gekennzeichnet, dass** es folgende Schritte umfasst:
- das Nehmen eines Donor-Substrats (1, 1'), welches innen eine Ätzstoppschicht (7, 7') umfasst und an einer seiner Seiten (12), der sogenannten "vorderen" Seite, mit einer Schaltungsschicht (2) bedeckt ist,
- an besagtem Umfang des besagten Donor-Substrats (1, 1') an jener Seite, die mit der Schaltungsschicht (2) bedeckt ist, entweder das Herstellen eines umlaufenden Grabens (3), der sich in einer Entfernung kleiner oder gleich 5 mm vom seitlichen Rand (13) dieses Substrats (1, 1') erstreckt, oder eines umlaufenden Zuschnitts (3), wobei dieser Zuschnitt (3') oder die Herstellung des Grabens (3) über eine Tiefe erfolgen, die dergestalt ist, dass sie komplett durch die Schaltungsschicht (2) hindurchführen und sich im Donor-Substrat (1, 1') fortsetzen.
- das Auftragen auf der exponierten Seite (21) der besagten Schaltungsschicht (2) und an der zugeschnittenen Seite (13') oder an den Wänden des besagten Grabens (3) einer Schicht eines Stoppmaterials (4), das in Bezug auf das Ätzen der besagten Schaltungsschicht (2), der sogenannten "zweiten Stoppschicht", ausgewählt wird, ohne besagten Graben (3) zu verschließen,
- das Ankleben eines Rezeptor-Substrats (1, 1') an der Seite, die mit besagter zweiter Stoppschicht (4) bedeckt ist,
- das Schmälern des Donator-Substrats (1) durch chemisches Ätzen an dessen Rückseite (11), bis besagter Ätzstoppbereich (7, 7') erreicht wird, so dass es zum Transfer der besagten vergrabenen Schaltungsschicht (2) auf besagtes Rezeptor-Substrat (5) kommt.

2. Verfahren nach Anspruch 1, **dadurch gekennzeichnet, dass** besagte Ätzstoppschicht eine sogenannte "erste Stoppschicht" (7) eines Materials ist, das in Bezug auf das Ätzen des Materials des hinteren Bereichs (101) des Donator-Substrats (1) ausgewählt wird.

3. Verfahren nach Anspruch 1, **dadurch gekennzeichnet, dass** besagter Ätzstoppbereich eine Grenzfläche (7') zwischen einer dotierten vorderen Schicht (102') und einer undotierten hinteren Schicht (101') des Donator-Substrats (1') ist.

4. Verfahren nach einem der vorhergehenden Ansprüche, **dadurch gekennzeichnet, dass** der umlaufende Zuschnitt (3') oder der umlaufende Graben (3) eine Tiefe aufweisen, die dergestalt ist, dass sie durch besagten Ätzstoppbereich (7, 7') hindurchführen, ohne in den hinteren Teil (101) oder die hintere Schicht (101') des Donator-Substrats (1, 1') vorzudringen.

5. Verfahren nach einem der Ansprüche 1 bis 3, **dadurch gekennzeichnet, dass** der umlaufende Zuschnitt (3') oder die Herstellung des umlaufenden Grabens (3) über eine Tiefe erfolgen, die dergestalt ist, dass sie nicht durch besagten Ätzstoppbereich (7, 7') hindurchführen und dadurch, dass auf den Schritt der Schmälerung durch chemische Ätzung ein Schritt der mechanischen Beseitigung des umlaufenden verbleibenden Kranzes (14) des Donator-Substrats (1, 1'), insbesondere durch Schleifen oder mechanisch-chemisches Polieren, folgt.

6. Verfahren nach einem der Ansprüche 1 bis 3, **dadurch gekennzeichnet, dass** der umlaufende Zuschnitt (3') oder der umlaufende Graben (3) eine Tiefe aufweisen, die dergestalt ist, dass sie durch besagten Ätzstoppbereich (7, 7') hindurchdurchführen und im hinteren Teil (101) oder der hinteren Schicht (101') des Donator-Substrats (1, 1') fortgesetzt werden, und dadurch, dass auf den Schritt der Schmälerung durch chemisches Ätzen ein Schritt der mechanischen Beseitigung des Rückstands (41) der besagten zweiten Stoppschicht (4), insbesondere durch Schleifen oder mechanisch-chemisches Polieren, folgt.

7. Verfahren nach einem der vorhergehenden Ansprüche, **dadurch gekennzeichnet, dass** die zweite Stoppschicht (4) mit einer Technik aufgetragen wird, die aus der chemischen Gasphasenabscheidung (CVD) oder dem Aufschleudern ausgewählt wird.

8. Verfahren nach einem der vorhergehenden Ansprüche, **dadurch gekennzeichnet, dass** der umlaufende Graben (3) mithilfe einer Technik hergestellt wird, die aus Lasergravur, Trockenätzen und Flüssigätzen ausgewählt wird.

9. Verfahren nach einem der vorhergehenden Ansprüche, **dadurch gekennzeichnet, dass** die Breite (L1) des Grabens (3) zwischen 10 µm und 500 µm beträgt.

10. Verfahren nach einem der vorhergehenden Ansprüche, **dadurch gekennzeichnet, dass** die Materialien, welche die erste (7) und die zweite (4) Stoppschicht bilden, aus Oxiden und Nitriden ausgewählt wird.

11. Verfahren nach Anspruch 10, **dadurch gekennzeichnet, dass** die Materialien, welche die erste (7) und die zweite (4) Stoppschicht bilden, aus Siliziumoxid (Si02), Siliciumoxynitrid (SiOₓN_{y}) oder Siliziumoxycarbid (SiO_{X}C_{Y}) ausgewählt werden.

12. Verfahren nach einem der vorhergehenden Ansprüche, **dadurch gekennzeichnet, dass** die Materialien, welche die erste (7) und die zweite (4) Stoppschicht bilden, identisch sind.

13. Verfahren nach einem der vorhergehenden Ansprüche, **dadurch gekennzeichnet, dass** das Donator-Substrat (1) aus einem Halbleitermaterial hergestellt wird.

14. Verfahren nach einem der vorhergehenden Ansprüche, **dadurch gekennzeichnet, dass** das Kleben des Donator-Substrats (1) und des Rezeptor-Substrats (5) durch molekulare Haftung erfolgt.

## Claims

1. A method for transferring a buried circuit layer (2), **characterised in that** it comprises the following steps:
• taking a donor substrate (1, 1') comprising internally an etching stop zone (7, 7') and covered, on one of the faces (12) thereof, referred to as the "front" face, a circuit layer (2),
• producing, on the entire circumference of said donor substrate (1, 1'), on the same side as the face thereof covered with the circuit layer (2), either a peripheral trench (3) that extends at a distance from the lateral edge (13) of this substrate (1, 1') that is less than or equal to 5 mm, or a peripheral cropping (3'), this cropping (3') or trench (3) being produced over a depth such that they pass entirely through the circuit layer (2) and are extended into the donor substrate (1, 1'),
• depositing, on the exposed face (21) of said circuit layer (2) and on the cropped face (13') or on the walls of said trench (3), a layer of stop material (4) selective vis-a-vis the etching of said circuit layer (2), referred to as the "second stop layer", without obstructing said trench (3),
• bonding a receiver substrate (5) on said donor substrate (1, 1') on the side covered by said second stop layer (4),
• thinning the donor substrate (1) by chemical etching of the rear face (11) thereof, until said etching stop zone (7, 7') is reached, so as to obtain the transfer of said buried circuit layer (2) onto said receiver substrate (5).

2. The method according to claim 1, **characterised in that** said etching stop zone is a layer (7) referred to as the "first stop layer", made from a material selective vis-a-vis the etching of the material of the rear part (101) of the donor substrate (1).

3. The method according to claim 1, **characterised in that** said etching stop zone is an interface (7') between a doped front layer (102') and a non-doped rear layer (101') of the donor substrate (1').

4. The method according to any of the preceding claims, **characterised in that** the peripheral cropping (3') or the peripheral trench (3) has a depth such that it passes through said etching stop zone (7, 7') without penetrating the rear part (101) or the rear layer (101') of the donor substrate (1, 1').

5. The method according to any of claims 1 to 3, **characterised in that** the peripheral cropping (3') or the peripheral trench (3) is produced over a depth such that it does not pass through said etching stop zone (7, 7'), and **in that**, after the step of thinning by chemical etching, a supplementary step of mechanical elimination of the residual peripheral crown (14) of the donor substrate (1, 1') is carried out, in particular by grinding or chemical mechanical polishing (CMP).

6. The method according to any of claims 1 to 3, **characterised in that** the peripheral cropping (3') or the peripheral trench (3) has a depth such that it passes through said etching stop zone (7, 7') and is extended in the rear part (101) or the rear layer (101') of the donor substrate (1, 1') and **in that**, after the step of thinning by chemical etching, a supplementary step of mechanical elimination of the residue (41) of said second stop layer (4) is carried out, in particular by grinding or chemical mechanical polishing (CMP).

7. The method according to any of the preceding claims, **characterised in that** the second stop layer (4) is deposited by a technique chosen from chemical vapour deposition (CVD) or rotation deposition.

8. The method according to any of the preceding claims, **characterised in that** the peripheral trench (3) is produced by means of a technique chosen from laser etching, dry etching and liquid etching.

9. The method according to any of the preceding claims, **characterised in that** the width (L1) of the trench (3) is between 10 µm and 500 µm.

10. The method according to any of the preceding claims, **characterised in that** the material constituting the first (7) and second (4) stop layers are chosen from oxides or nitrides.

11. The method according to claim 10, **characterised in that** the materials constituting the first (7) and second (4) stop layers are chosen from silicon oxide (SiO₂), silicon oxynitride (SiOₓN_{y}) or silicon oxycarbide (SiOₓC_{y}).

12. The method according to any of the preceding claims, **characterised in that** the materials constituting the first (7) and the second (4) stop layers are identical.

13. The method according to any of the preceding claims, **characterised in that** the donor substrate (1) is produced from a semiconductive material.

14. The method according to any of the preceding claims, **characterised in that** the donor (4) and receiver (5) substrates are bonded by molecular adhesion.
